# EUROPEAN PATENT SPECIFICATION

(11) **EP 3 625 568 B1**
(45) Date of publication and mention of the grant of the patent: **28.06.2023**
(21) Application number: 18865190.5
(22) Date of filing: 04.10.2018
(51) Int. Cl.: G01N 35/02, G01N 35/04

(54) **CAROUSEL FOR SLIDES WITH DIFFERENT SIZES**
KARUSSELL FÜR OBJEKTTRÄGER MIT UNTERSCHIEDLICHEN GRÖSSEN
CARROUSEL POUR DIAPOSITIVES DE DIFFÉRENTES TAILLES

(30) Priority: 04.10.2017 US 201762568206 P
(43) Date of publication of application: 25.03.2020
(73) Proprietor: Leica Biosystems Imaging, Inc., Vista, CA 92081 (US)
(72) Inventor: NEWBERG, Nicholas, Vista, California 92081 (US); DJELOSEVIC, Prentash, Vista, California 92081 (US)
(74) Representative: Anetsberger, Georg
(86) International application number: PCT/US2018/054462
(87) International publication number: WO 2019/071042

(56) References cited:
- EP-A1- 2 333 563
- EP-A2- 0 458 138
- WO-A1-2006/098441
- WO-A2-2013/170366
- CN-U- 202 057 667
- JP-A- H06 171 685
- JP-A- 2007 084 111
- US-A- 4 761 075
- US-A- 5 019 927
- US-A1- 2001 018 031

## Description

### CROSS-REFERENCE TO RELATED APPLICATIONS

The present application claims priority to U.S. Provisional Patent Application No. 62/568,206, filed on October 4, 2017.

### BACKGROUND

### Field of the Invention

The present invention generally relates to a digital slide scanning apparatus and more particularly relates to a carousel that supports variable sized slide racks (e.g., 1x3 and 2x3 slide racks that store glass slides for digital pathology).

### Related Art

Digital pathology is an image-based information environment which is enabled by computer technology that allows for the management of information generated from a physical slide. Digital pathology is enabled in part by virtual microscopy, which is the practice of scanning a specimen on a physical glass slide and creating a digital slide image that can be stored, viewed, managed, and analyzed on a computer monitor. With the capability of imaging an entire glass slide, the field of digital pathology has exploded and is currently regarded as one of the most promising avenues of diagnostic medicine in order to achieve even better, faster and cheaper diagnosis, prognosis, and prediction of important diseases, such as cancer.

The majority of physical glass slides are 76x26mm (1×3 inch, 2.54 × 7.62 cm). However, some glass slides are 76×52mm (2×3 inch, 5.08 × 7.62 cm) These larger glass slides are double-wide. A digital slide scanning apparatus typically scans a single slide at a time. Some digital slide scanning apparatus have been modified to hold one or more slide racks so that the digital slide scanning apparatus can sequentially process tens or hundreds of glass slides without interruption. However, the conventional digital slide scanner apparatus is not able to hold slide racks of varying sizes or interleave scanning of variable sized glass slides without interruption. Therefore, what is needed is a system and method that overcomes these significant problems found in the conventional systems as described above. EP 0 458 138 discloses an analyser with a carousel for holding slides in a rack. JP 2007 084111 discloses a slide rack for slides with different sizes.

### SUMMARY

Accordingly, described herein is a slide rack carousel for use with a digital slide scanning apparatus that is configured to hold slide racks of varying sizes. The slide rack carousel includes a base that is configured to support a plurality of slide rack spacers that extend upward from an upper surface of the base. The plurality of slide rack spacers may include slide rack spacers of varying sizes. Adjacent slide rack spacers define a slide rack slot of a predetermined size. A plurality of slide rack slot sizes can be selectively configured on the carousel in accordance with the positioning and size of the plurality of slide rack spacers that are attached to the base of the carousel. Accordingly, a desired number of 1x3 slide rack slots and a desired number of 2x3 slide rack slots can be configured on the base of the slide rack carousel.

In an embodiment, a digital slide scanning apparatus carousel comprises a base having a lower surface, an upper surface and an exterior edge, the exterior edge of the base being generally circular from a top view perspective. The carousel also includes a plurality of rack spacers positioned above the base, each rack spacer having a left side, a right side, an exterior side, an interior side, a top and a bottom. A first adjacent pair of rack spacers comprising a first rack spacer and a second rack spacer defines a first 1x3 rack slot bordered on three sides by the base, a left side of the first rack spacer and a right side of the second rack spacer. Additionally, a second adjacent pair of rack spacers comprising a third rack spacer and a fourth rack spacer defines a first 2x3 rack slot bordered on three sides by the base, a left side of the third rack spacer and a right side of the fourth rack spacer.

Other features and advantages of the present invention will become more readily apparent to those of ordinary skill in the art after reviewing the following detailed description and accompanying drawings.

### BRIEF DESCRIPTION OF THE DRAWINGS

The structure and operation of the present invention will be understood from a review of the following detailed description and the accompanying drawings in which like reference numerals refer to like parts and in which:
FIG. 1 is a top view diagram illustrating an example slide rack carousel base with rack spacer connectors according to an embodiment;
FIG. 2 is a top view diagram illustrating an example slide rack carousel base with removable rack spacers connected to the base according to an embodiment;
FIG. 3 is a top view diagram illustrating an example 1x3 slide rack with glass slides according to an embodiment;
FIG. 4 is a top view diagram illustrating an example 2x3 slide rack with glass slides according to an embodiment;
FIG. 5 is a perspective view diagram illustrating an example slide rack carousel base with different sized rack spacers defining variable sized rack slots occupied by different sized slide racks having glass slides according to an embodiment;
FIG. 6A is a block diagram illustrating an example processor enabled device 550 that may be used in connection with various embodiments described herein;
FIG. 6B is a block diagram illustrating an example line scan camera having a single linear array;
FIG. 6C is a block diagram illustrating an example line scan camera having three linear arrays; and
FIG. 6D is a block diagram illustrating an example line scan camera having a plurality of linear arrays.

### DETAILED DESCRIPTION

Embodiments disclosed herein provide for a slide rack carousel that is configurable to have a desired number of 1x3 rack slots in combination with a desired number of 2x3 rack slots. After reading this description it will become apparent to one skilled in the art how to implement the invention in various alternative embodiments and alternative applications. However, although various embodiments of the present invention will be described herein, it is understood that these embodiments are presented by way of example only, and not limitation.

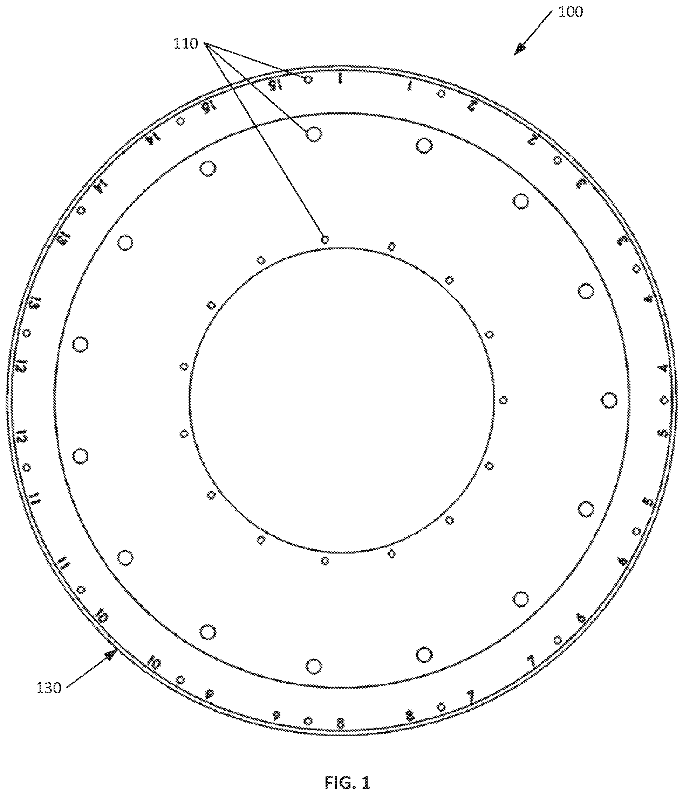

FIG. 1 is a top view diagram illustrating an example slide rack carousel base 100 with rack spacer connectors 110 according to an embodiment. In the illustrated embodiment, the upper surface 120 of the base 100 has a plurality of rack spacer connectors 110 that are configured to attach a plurality of rack spacers. In one embodiment, the shape of a perimeter edge 130 of the carousel base 100 is generally circular. In one embodiment, the generally circular shaped base 100 is in the form of a ring.

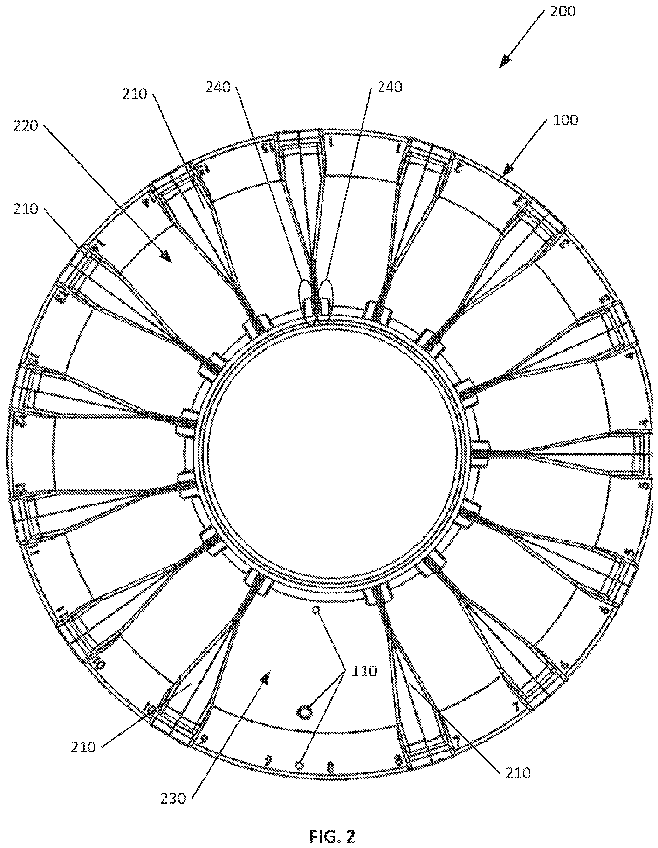

FIG. 2 is a top view diagram illustrating an example slide rack carousel 200 having a base 100 with removable rack spacers 210 attached to the base 100 by one or more connectors 110 according to an embodiment. In the illustrated embodiment, each rack spacer 210 comprises a first rack stopper 240 on a first side and a second rack stopper 240 on a second side. Each of the first and second rack stoppers 240 of a single rack spacer face different rack slots (220, 230). Accordingly, a first rack stopper 240 of a first rack spacer 210 and a second rack stopper 240 of a second rack spacer 210 face each other. Advantageously, the distance between the first rack stopper 240 and the second rack stopper 240 of a particular rack slot (220, 230) is less than the width of the particular rack slot (220, 230) and correspondingly less than the width of a slide rack that the particular rack slot (220, 230) is configured to hold. In this fashion, the combination of opposing first rack stopper 240 and second rack stopper 240 prevent a slide rack from traveling any further toward the center of the slide rack carousel 200.

Advantageously, one or more of the plurality of rack spacers 210 have different sizes and are configured to be detached from the base 100 of the carousel 200. Accordingly, a pair of rack spacers 210 may define a 1x3 rack slot 220 or a 2x3 rack slot 230.

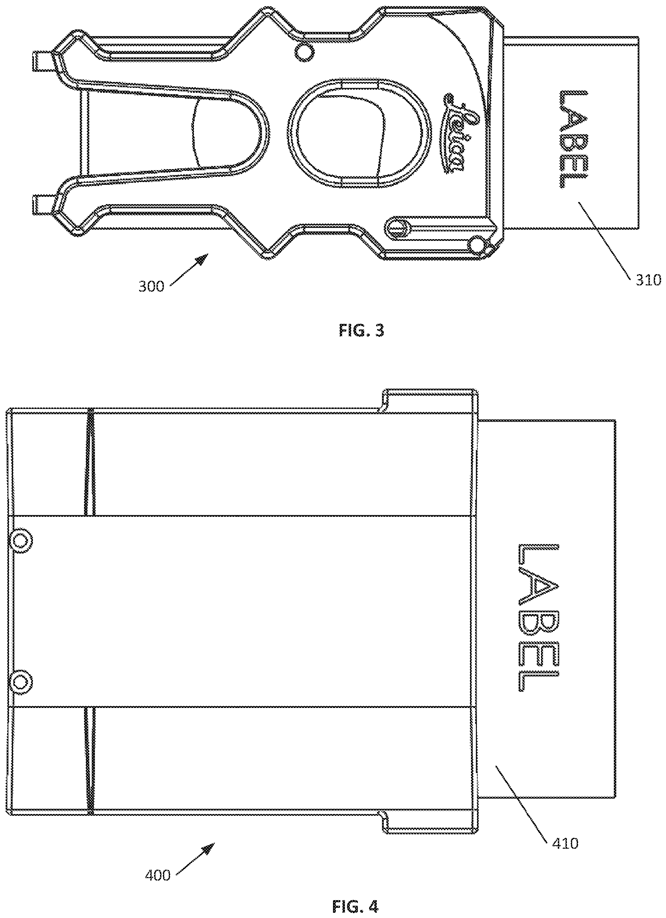

FIG. 3 is a top view diagram illustrating an example 1x3 slide rack 300 with glass slides 310 according to an embodiment. In the illustrated embodiment, the slide rack 300 is configured to support a plurality of glass slides 310 that are each 1x3 in size. The width of the slide rack 300 is slightly larger than the 1x3 size of the glass slides 310. Although this is a top view of the slide rack 300, it will be understood that that height of the slide rack may vary and different 1x3 slide racks 300 may therefore be configured to hold a different maximum number of glass slides 310.

FIG. 4 is a top view diagram illustrating an example 2x3 slide rack 400 with glass slides 410 according to an embodiment. In the illustrated embodiment, the slide rack 400 is configured to support a plurality of glass slides 410 that are each 2x3 in size. The width of the slide rack 400 is slightly larger than the 2x3 size of the glass slides 410. Although this is a top view of the slide rack 400, it will be understood that that height of the slide rack 400 may vary and different 2x3 slide racks 400 may therefore be configured to hold a different maximum number of glass slides 410.

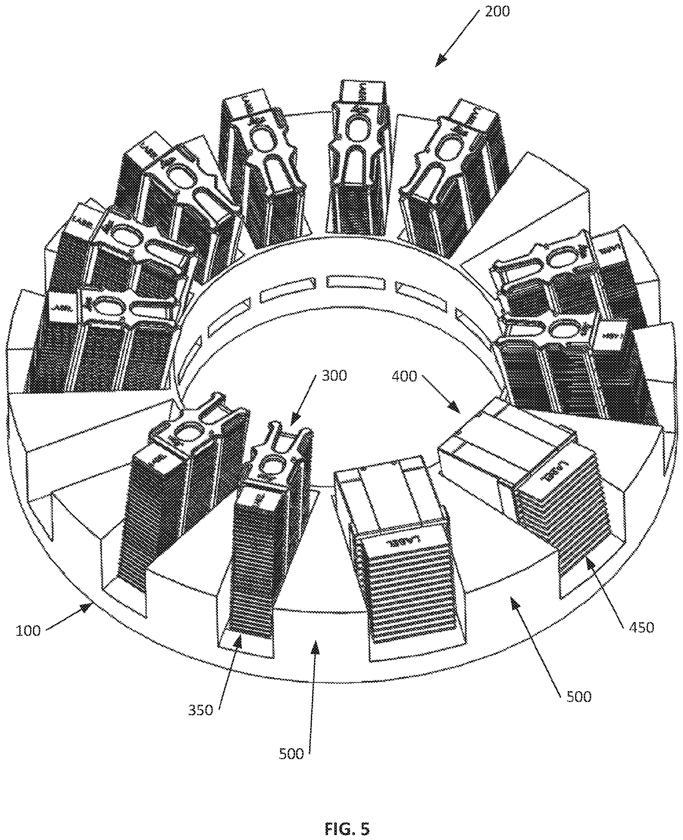

FIG. 5 is a perspective view diagram illustrating an example slide rack carousel 200 having a base 100 with different sized rack spacers 500 defining different sized rack slots (350, 450) that are occupied by different sized slide racks (300, 400) having glass slides according to an embodiment. In the illustrated embodiment, the carousel 200 includes a plurality of rack spacers 500 that have different sizes. The rack spacers 500 are generally wedge shaped. The facing sides of each pair of adjacent rack spacers 500 are generally parallel and thereby define a generally rectangular rack slot (350, 450) from a top view perspective. The illustrated configuration of the carousel 200 includes a plurality of 1x3 sized rack slots 350, each configured to hold a 1x3 slide rack 300 and a plurality of 2x3 sized rack slots 450, each configured to hold a 2x3 slide rack 400. The individual slide racks (300, 400), whether 1x3 or 2x3 may have different heights and thereby accommodate a different maximum number of glass slides.

### EXAMPLE EMBODIMENTS

The invention is set out in the appended set of claims. In one embodiment, the carousel is deployed in a digital slide scanner apparatus that has a housing with an opening configured to allow operator access to at least at portion of the carousel. Advantageously, the removable rack spacers are configured to be inserted through the opening in the housing and attached to the base of the carousel. The removable rack spacers are also configured to detached from the base of the carousel and removed through the opening in the housing. In this fashion, the carousel of the digital slide scanner apparatus can be reconfigured as needed to hold different size slide racks.

In one embodiment, a digital slide scanning apparatus carousel includes a base having a lower surface, an upper surface and an exterior edge, the exterior edge of the base being generally circular from a top view perspective. The carousel also includes a plurality of rack spacers connected to the base and extending upward from the base. Each rack spacer has a left side, a right side, an exterior side, an interior side, a top and a bottom. A pair of adjacent rack spacers defines a rack slot having a particular size. For example, a first adjacent pair of rack spacers includes a first rack spacer and a second rack spacer that define a first 1x3 rack slot bordered on three sides by the base, a left side of a first rack spacer and a right side of a second rack spacer. Additionally, a second adjacent pair of rack spacers includes a third rack spacer and a fourth rack spacer that define a first 2x3 rack slot bordered on three sides by the base, a left side of the third rack spacer and a right side of the fourth rack spacer.

In one embodiment, the left side of the first rack spacer and the right side of the second rack spacer that define the first 1x3 rack slot are substantially parallel. For example, each of the first rack spacer and the second rack spacer may be generally wedge shaped. Additionally, in this embodiment the first 1x3 rack slot is generally rectangular from a top view. Also in this embodiment, the first 1x3 rack slot is configured to hold a 1x3 slide rack.

In one embodiment, the left side of the third rack spacer and the right side of the fourth rack spacer that define the first 2x3 rack slot are substantially parallel. For example, each of the first rack spacer and the second rack spacer may be generally wedge shaped. Additionally, in this embodiment the first 2x3 rack slot is generally rectangular from a top view. Also in this embodiment, the first 2x3 rack slot is configured to hold a 2x3 slide rack.

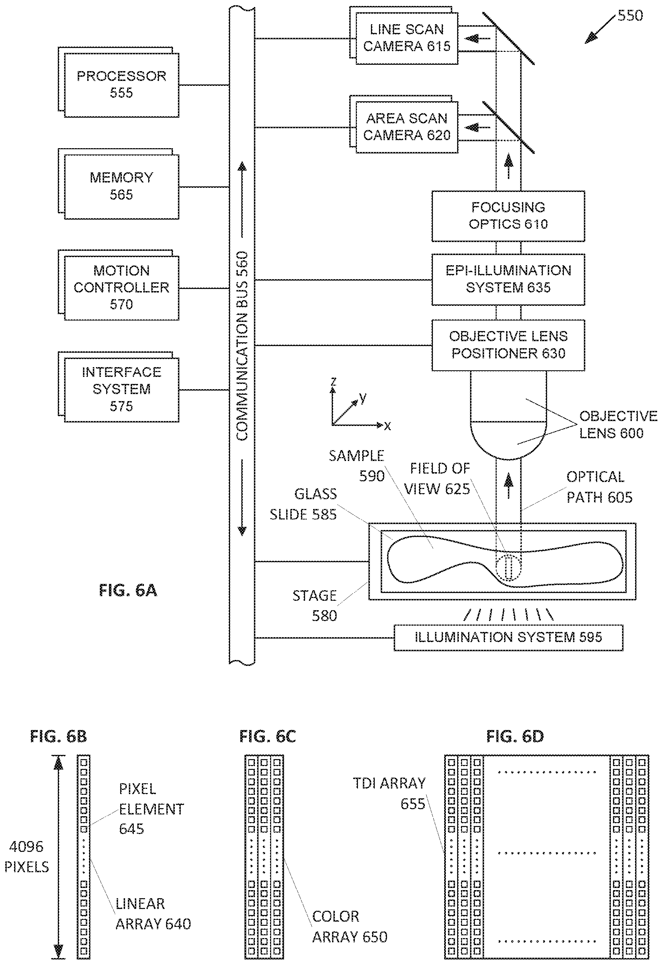

FIG. 6A is a block diagram illustrating an example processor enabled device 550 that may be used in connection with various embodiments described herein. Alternative forms of the device 550 may also be used as will be understood by the skilled artisan. In the illustrated embodiment, the device 550 is presented as a digital imaging device (also referred to herein as a scanner system, a scanning system, a scanning apparatus, a digital scanning apparatus, a digital slide scanning apparatus, etc.) that comprises one or more processors 555, one or more memories 565, one or more motion controllers 570, one or more interface systems 575, one or more movable stages 580 that each support one or more glass slides 585 with one or more samples 590, one or more illumination systems 595 that illuminate the sample, one or more objective lenses 600 that each define an optical path 605 that travels along an optical axis, one or more objective lens positioners 630, one or more optional epi-illumination systems 635 (e.g., included in a fluorescence scanner system), one or more focusing optics 610, one or more line scan cameras 615 and/or one or more additional cameras 620 (e.g., a line scan camera or an area scan camera), each of which define a separate field of view 625 on the sample 590 and/or glass slide 585. The various elements of the scanner system 550 are communicatively coupled via one or more communication busses 560. Although there may be one or more of each of the various elements of the scanner system 550, for the sake of simplicity, these elements will be described herein in the singular except when needed to be described in the plural to convey the appropriate information.

The one or more processors 555 may include, for example, a central processing unit ("CPU") and a separate graphics processing unit ("GPU") capable of processing instructions in parallel or the one or more processors 555 may include a multicore processor capable of processing instructions in parallel. Additional separate processors may also be provided to control particular components or perform particular functions such as image processing. For example, additional processors may include an auxiliary processor to manage data input, an auxiliary processor to perform floating point mathematical operations, a special-purpose processor having an architecture suitable for fast execution of signal processing algorithms (e.g., digital signal processor), a slave processor subordinate to the main processor (e.g., back-end processor), an additional processor for controlling the line scan camera 615, the stage 580, the objective lens 225, and/or a display (not shown). Such additional processors may be separate discrete processors or may be integrated with the processor 555.

The memory 565 provides storage of data and instructions for programs that can be executed by the processor 555. The memory 565 may include one or more volatile and/or non-volatile computer-readable storage mediums that store the data and instructions, including, for example, a random access memory, a read only memory, a hard disk drive, a removable storage drive, and/or the like. The processor 555 is configured to execute instructions that are stored in the memory 565 and communicate via communication bus 560 with the various elements of the scanner system 550 to carry out the overall function of the scanner system 550.

The one or more communication busses 560 may include a communication bus 560 that is configured to convey analog electrical signals and may include a communication bus 560 that is configured to convey digital data. Accordingly, communications from the processor 555, the motion controller 570, and/or the interface system 575 via the one or more communication busses 560 may include both electrical signals and digital data. The processor 555, the motion controller 570, and/or the interface system 575 may also be configured to communicate with one or more of the various elements of the scanning system 550 via a wireless communication link.

The motion control system 570 is configured to precisely control and coordinate X, Y, and/or Z movement of the stage 580 (e.g., within an X-Y plane) and/or the objective lens 600 (e.g., along a Z axis orthogonal to the X-Y plane, via the objective lens positioner 630). The motion control system 570 is also configured to control movement of any other moving part in the scanner system 550. For example, in a fluorescence scanner embodiment, the motion control system 570 is configured to coordinate movement of optical filters and the like in the epi-illumination system 635.

The interface system 575 allows the scanner system 550 to interface with other systems and human operators. For example, the interface system 575 may include a user interface to provide information directly to an operator and/or to allow direct input from an operator. The interface system 575 is also configured to facilitate communication and data transfer between the scanning system 550 and one or more external devices that are directly connected (e.g., a printer, removable storage medium) or external devices such as an image server system, an operator station, a user station, and an administrative server system that are connected to the scanner system 550 via a network (not shown).

The illumination system 595 is configured to illuminate a portion of the sample 590. The illumination system may include, for example, a light source and illumination optics. The light source may comprise a variable intensity halogen light source with a concave reflective mirror to maximize light output and a KG-1 filter to suppress heat. The light source could also comprise any type of arc-lamp, laser, or other source of light. In one embodiment, the illumination system 595 illuminates the sample 590 in transmission mode such that the line scan camera 615 and/or camera 620 sense optical energy that is transmitted through the sample 590. Alternatively, or in combination, the illumination system 595 may also be configured to illuminate the sample 590 in reflection mode such that the line scan camera 615 and/or camera 620 sense optical energy that is reflected from the sample 590. The illumination system 595 may be configured to be suitable for interrogation of the microscopic sample 590 in any known mode of optical microscopy.

In one embodiment, the scanner system 550 optionally includes an epi-illumination system 635 to optimize the scanner system 550 for fluorescence scanning. Fluorescence scanning is the scanning of samples 590 that include fluorescence molecules, which are photon sensitive molecules that can absorb light at a specific wavelength (excitation). These photon sensitive molecules also emit light at a higher wavelength (emission). Because the efficiency of this photoluminescence phenomenon is very low, the amount of emitted light is often very low. This low amount of emitted light typically frustrates conventional techniques for scanning and digitizing the sample 590 (e.g., transmission mode microscopy). Advantageously, in an optional fluorescence scanner system embodiment of the scanner system 550, use of a line scan camera 615 that includes multiple linear sensor arrays (e.g., a time delay integration ("TDI") line scan camera) increases the sensitivity to light of the line scan camera by exposing the same area of the sample 590 to each of the multiple linear sensor arrays of the line scan camera 615. This is particularly useful when scanning faint fluorescence samples with low emitted light.

Accordingly, in a fluorescence scanner system embodiment, the line scan camera 615 is preferably a monochrome TDI line scan camera. Advantageously, monochrome images are ideal in fluorescence microscopy because they provide a more accurate representation of the actual signals from the various channels present on the sample. As will be understood by those skilled in the art, a fluorescence sample 590 can be labeled with multiple florescence dyes that emit light at different wavelengths, which are also referred to as "channels."

Furthermore, because the low and high end signal levels of various fluorescence samples present a wide spectrum of wavelengths for the line scan camera 615 to sense, it is desirable for the low and high end signal levels that the line scan camera 615 can sense to be similarly wide. Accordingly, in a fluorescence scanner embodiment, a line scan camera 615 used in the fluorescence scanning system 550 is a monochrome 10 bit 64 linear array TDI line scan camera. It should be noted that a variety of bit depths for the line scan camera 615 can be employed for use with a fluorescence scanner embodiment of the scanning system 550.

The movable stage 580 is configured for precise X-Y movement under control of the processor 555 or the motion controller 570. The movable stage may also be configured for Z movement under control of the processor 555 or the motion controller 570. The movable stage is configured to position the sample in a desired location during image data capture by the line scan camera 615 and/or the area scan camera. The movable stage is also configured to accelerate the sample 590 in a scanning direction to a substantially constant velocity and then maintain the substantially constant velocity during image data capture by the line scan camera 615. In one embodiment, the scanner system 550 may employ a high precision and tightly coordinated X-Y grid to aid in the location of the sample 590 on the movable stage 580. In one embodiment, the movable stage 580 is a linear motor based X-Y stage with high precision encoders employed on both the X and the Y axis. For example, very precise nanometer encoders can be used on the axis in the scanning direction and on the axis that is in the direction perpendicular to the scanning direction and on the same plane as the scanning direction. The stage is also configured to support the glass slide 585 upon which the sample 590 is disposed.

The sample 590 can be anything that may be interrogated by optical microscopy. For example, a glass microscope slide 585 is frequently used as a viewing substrate for specimens that include tissues and cells, chromosomes, DNA, protein, blood, bone marrow, urine, bacteria, beads, biopsy materials, or any other type of biological material or substance that is either dead or alive, stained or unstained, labeled or unlabeled. The sample 590 may also be an array of any type of DNA or DNA-related material such as cDNA or RNA or protein that is deposited on any type of slide or other substrate, including any and all samples commonly known as a microarrays. The sample 590 may be a microtiter plate, (e.g., a 96-well plate). Other examples of the sample 590 include integrated circuit boards, electrophoresis records, petri dishes, film, semiconductor materials, forensic materials, or machined parts.

Objective lens 600 is mounted on the objective positioner 630 which, in one embodiment, employs a very precise linear motor to move the objective lens 600 along the optical axis defined by the objective lens 600. For example, the linear motor of the objective lens positioner 630 may include a 50 nanometer encoder. The relative positions of the stage 580 and the objective lens 600 in X, Y, and/or Z axes are coordinated and controlled in a closed loop manner using motion controller 570 under the control of the processor 555 that employs memory 565 for storing information and instructions, including the computer-executable programmed steps for overall scanning system 550 operation.

In one embodiment, the objective lens 600 is a plan apochromatic ("APO") infinity corrected objective with a numerical aperture corresponding to the highest spatial resolution desirable, where the objective lens 600 is suitable for transmission mode illumination microscopy, reflection mode illumination microscopy, and/or epi-illumination mode fluorescence microscopy (e.g., an Olympus 40X, 0.75NA or 20X, 0.75 NA). Advantageously, objective lens 600 is capable of correcting for chromatic and spherical aberrations. Because objective lens 600 is infinity corrected, focusing optics 610 can be placed in the optical path 605 above the objective lens 600 where the light beam passing through the objective lens becomes a collimated light beam. The focusing optics 610 focus the optical signal captured by the objective lens 600 onto the light-responsive elements of the line scan camera 615 and/or the area scan camera 620 and may include optical components such as filters, magnification changer lenses, and/or the like. The objective lens 600 combined with the focusing optics 610 provides the total magnification for the scanning system 550. In one embodiment, the focusing optics 610 may contain a tube lens and an optional 2X magnification changer. Advantageously, the 2X magnification changer allows a native 20X objective lens 600 to scan the sample 590 at 40X magnification.

The line scan camera 615 comprises at least one linear array of picture elements ("pixels"). The line scan camera may be monochrome or color. Color line scan cameras typically have at least three linear arrays, while monochrome line scan cameras may have a single linear array or plural linear arrays. Any type of singular or plural linear array, whether packaged as part of a camera or custom-integrated into an imaging electronic module, can also be used. For example, 3 linear array ("red-green-blue" or "RGB") color line scan camera or a 96 linear array monochrome TDI may also be used. TDI line scan cameras typically provide a substantially better signal-to-noise ratio ("SNR") in the output signal by summing intensity data from previously imaged regions of a specimen, yielding an increase in the SNR that is in proportion to the square-root of the number of integration stages. TDI line scan cameras comprise multiple linear arrays, for example, TDI line scan cameras are available with 24, 32, 48, 64, 96, or even more linear arrays. The scanner system 550 also supports linear arrays that are manufactured in a variety of formats including some with 512 pixels, some with 1024 pixels, and others having as many as 4096 pixels. Similarly, linear arrays with a variety of pixel sizes can also be used in the scanner system 550. The salient requirement for the selection of any type of line scan camera 615 is that the motion of the stage 580 can be synchronized with the line rate of the line scan camera 615 so that the stage 580 can be in motion with respect to the line scan camera 615 during the digital image capture of the sample 590.

The image data generated by the line scan camera 615 is stored a portion of the memory 565 and processed by the processor 555 to generate a contiguous digital image of at least a portion of the sample 590. The contiguous digital image can be further processed by the processor 555 and the revised contiguous digital image can also be stored in the memory 565.

In an embodiment with two or more line scan cameras 615, at least one of the line scan cameras 615 can be configured to function as a focusing sensor that operates in combination with at least one of the other line scan cameras 615 that is configured to function as an imaging sensor. The focusing sensor can be logically positioned on the same optical axis as the imaging sensor or the focusing sensor may be logically positioned before or after the imaging sensor with respect to the scanning direction of the scanner system 550. In such an embodiment with at least one line scan camera 615 functioning as a focusing sensor, the image data generated by the focusing sensor is stored in a portion of the memory 565 and processed by the one or more processors 555 to generate focus information to allow the scanner system 550 to adjust the relative distance between the sample 590 and the objective lens 600 to maintain focus on the sample during scanning. Additionally, in one embodiment the at least one line scan camera 615 functioning as a focusing sensor may be oriented such that each of a plurality of individual pixels of the focusing sensor is positioned at a different logical height along the optical path 605.

In operation, the various components of the scanner system 550 and the programmed modules stored in memory 565 enable automatic scanning and digitizing of the sample 590, which is disposed on a glass slide 585. The glass slide 585 is securely placed on the movable stage 580 of the scanner system 550 for scanning the sample 590. Under control of the processor 555, the movable stage 580 accelerates the sample 590 to a substantially constant velocity for sensing by the line scan camera 615, where the speed of the stage is synchronized with the line rate of the line scan camera 615. After scanning a stripe of image data, the movable stage 580 decelerates and brings the sample 590 to a substantially complete stop. The movable stage 580 then moves orthogonal to the scanning direction to position the sample 590 for scanning of a subsequent stripe of image data, e.g., an adjacent stripe. Additional stripes are subsequently scanned until an entire portion of the sample 590 or the entire sample 590 is scanned.

For example, during digital scanning of the sample 590, a contiguous digital image of the sample 590 is acquired as a plurality of contiguous fields of view that are combined together to form an image strip. A plurality of adjacent image strips are similarly combined together to form a contiguous digital image of a portion or the entire sample 590. The scanning of the sample 590 may include acquiring vertical image strips or horizontal image strips. The scanning of the sample 590 may be either top-to-bottom, bottom-to-top, or both (bi-directional) and may start at any point on the sample. Alternatively, the scanning of the sample 590 may be either left-to-right, right-to-left, or both (bi-directional) and may start at any point on the sample. Additionally, it is not necessary that image strips be acquired in an adjacent or contiguous manner. Furthermore, the resulting image of the sample 590 may be an image of the entire sample 590 or only a portion of the sample 590.

In one embodiment, computer-executable instructions (e.g., programmed modules and software) are stored in the memory 565 and, when executed, enable the scanning system 550 to perform the various functions described herein. In this description, the term "computer-readable storage medium" is used to refer to any media used to store and provide computer executable instructions to the scanning system 550 for execution by the processor 555. Examples of these media include memory 565 and any removable or external storage medium (not shown) communicatively coupled with the scanning system 550 either directly or indirectly, for example via a network (not shown).

FIG. 6B illustrates a line scan camera having a single linear array 640, which may be implemented as a charge coupled device ("CCD") array. The single linear array 640 comprises a plurality of individual pixels 645. In the illustrated embodiment, the single linear array 640 has 4096 pixels. In alternative embodiments, linear array 640 may have more or fewer pixels. For example, common formats of linear arrays include 512, 1024, and 4096 pixels. The pixels 645 are arranged in a linear fashion to define a field of view 625 for the linear array 640. The size of the field of view 625 varies in accordance with the magnification of the scanner system 550.

FIG. 6C illustrates a line scan camera having three linear arrays, each of which may be implemented as a CCD array. The three linear arrays combine to form a color array 650. In one embodiment, each individual linear array in the color array 650 detects a different color intensity, for example red, green, or blue. The color image data from each individual linear array in the color array 650 is combined to form a single field of view 625 of color image data.

FIG. 6D illustrates a line scan camera having a plurality of linear arrays, each of which may be implemented as a CCD array. The plurality of linear arrays combine to form a TDI array 655. Advantageously, a TDI line scan camera may provide a substantially better SNR in its output signal by summing intensity data from previously imaged regions of a specimen, yielding an increase in the SNR that is in proportion to the square-root of the number of linear arrays (also referred to as integration stages). A TDI line scan camera may comprise a larger variety of numbers of linear arrays, for example common formats of TDI line scan cameras include 24, 32, 48, 64, 96, 120 and even more linear arrays.

## Claims

1. A digital slide scanning apparatus carousel, comprising:
a base (100) having a lower surface, an upper surface and an exterior edge, the exterior edge of the base being generally circular from a top view perspective; **characterized in that**
a plurality of removable rack spacers (210) positioned above the base, each removable rack spacer (210) having a left side, a right side, an exterior side, an interior side, a top, and a bottom, wherein a plurality of rack spacer connectors (110) are formed on the upper surface of the base (100), and the removable rack spacers (210) configured to be attached to the base (100) by rack spacer connectors (110);
wherein a first adjacent pair of rack spacers comprising a first rack spacer and a second rack spacer to define a first rack slot (220) bordered on three sides by the base, a left side of the first rack spacer and a right side of the second rack spacer; and
wherein a second adjacent pair of rack spacers comprising a third rack spacer and a fourth rack spacer to define a second rack slot (230) bordered on three sides by the base (100), a left side of the third rack spacer and a right side of the fourth rack spacer;
wherein the rack slots are configured to hold a slide rack which is configured to hold slides.

2. The digital slide scanning apparatus carousel of claim 1, wherein the left side of the first rack spacer (210) and the right side of the second rack spacer (210) that define the first rack slot (220) are substantially parallel.

3. The digital slide scanning apparatus carousel of claim 2, wherein the first rack slot (220) defines a generally rectangular area on the upper surface of the base (100) from a top view.

4. The digital slide scanning apparatus carousel of claim 3, wherein the first slide rack (300) is configured to support a plurality of glass slides (310) that are each 2.54 cm by 7.62 cm in size.

5. The digital slide scanning apparatus carousel of claim 2, wherein each of the first rack spacer (210) and the second rack spacer (210) is generally wedge shaped.

6. The digital slide scanning apparatus carousel of claim 2, wherein the first rack spacer (210) and the second rack spacer (210) are connected to the base and extend upward from the base (100).

7. The digital slide scanning apparatus carousel of claim 2, wherein the first rack spacer comprises an interior portion proximal a central portion of the base (100) and further comprises a first rack stopper (240) extending from the interior portion of the first rack spacer (210) toward the second rack spacer (210) and into the first rack slot (220).

8. The digital slide scanning apparatus carousel of claim 7, wherein the second rack spacer (210) comprises an interior portion proximal a central portion of the base (100) and further comprises a second rack stopper (240) extending from the interior portion of the second rack spacer toward the first rack spacer and into the first rack slot.

9. The digital slide scanning apparatus carousel of claim 8, wherein the first rack stopper (240) and the second rack stopper (240) are configured to engage the first slide rack (300) positioned in the first rack slot (220).

10. The digital slide scanning apparatus carousel of claim 1, wherein the left side of the third rack spacer and the right side of the fourth rack spacer that define the second rack slot (230) are substantially parallel, wherein the second rack slot (230) defines a generally rectangular area on the upper surface of the base (100) from a top view, and wherein each of the third rack spacer and the fourth rack spacer is generally wedge shaped.

11. The digital slide scanning apparatus carousel of claim 10, wherein the second slide rack (400) is configured to support a plurality of glass slides (410) that are each 5.06 cm by 7.62 cm in size.

12. The digital slide scanning apparatus carousel of claim 10, wherein the third rack spacer and the fourth rack spacer are connected to the base (100) and extend upward from the base (100).

13. The digital slide scanning apparatus carousel of claim 10, wherein the third rack spacer comprises an interior portion proximal a central portion of the base (100) and further comprises a third rack stopper extending from the interior portion of the third rack spacer toward the fourth rack spacer and into the second rack slot (230).

14. The digital slide scanning apparatus carousel of claim 13, wherein the fourth rack spacer comprises an interior portion proximal a central portion of the base (100) and further comprises a fourth rack stopper extending from the interior portion of the fourth rack spacer toward the third rack spacer and into the second rack slot (230).

15. The digital slide scanning apparatus carousel of claim 14, wherein the third rack stopper and the fourth rack stopper are configured to engage the second slide rack (400), configured to support a plurality of glass slides (410) that are each 2 inches by 3 inches in size, positioned in the second rack slot (400).

## Patentansprüche

1. Karussell einer digitalen Objektträgerabtastvorrichtung, umfassend:
eine Basis (100) mit einer unteren Oberfläche, einer oberen Oberfläche und einer Außenkante, wobei die Außenkante der Basis aus einer Draufsicht im Allgemeinen kreisförmig ist;
**dadurch gekennzeichnet, dass** eine Mehrzahl von entfernbaren Gestellabstandshaltern (210) über der Basis positioniert ist, wobei jeder entfernbare Gestellabstandshalter (210) eine linke Seite, eine rechte Seite, eine Außenseite, eine Innenseite, eine Oberseite und eine Unterseite aufweist, wobei eine Mehrzahl von Gestellabstandshalterverbindern (110) auf der oberen Oberfläche der Basis (100) gebildet ist und die entfernbaren Gestellabstandshalter (210) konfiguriert sind, um durch Gestellabstandshalterverbinder (110) an der Basis (100) befestigt zu werden;
wobei ein erstes benachbartes Paar von Gestellabstandshaltern einen ersten Gestellabstandshalter und einen zweiten Gestellabstandshalter umfasst, um einen ersten Gestellschlitz (220) zu definieren, der auf drei Seiten durch die Basis, eine linke Seite des ersten Gestellabstandshalters und eine rechte Seite des zweiten Gestellabstandshalters begrenzt ist; und
wobei ein zweites benachbartes Paar von Gestellabstandshaltern einen dritten Gestellabstandshalter und einen vierten Gestellabstandshalter umfasst, um einen zweiten Gestellschlitz (230) zu definieren, der auf drei Seiten durch die Basis (100), eine linke Seite des dritten Gestellabstandshalters und eine rechte Seite des vierten Gestellabstandshalters begrenzt ist; wobei die Gestellschlitze konfiguriert sind, um ein Objektträgergestell zu halten, das konfiguriert ist, um Objektträger zu halten.

2. Karussell einer digitalen Objektträgerabtastvorrichtung nach Anspruch 1, wobei die linke Seite des ersten Gestellabstandshalters (210) und die rechte Seite des zweiten Gestellabstandshalters (210), die den ersten Gestellschlitz (220) definieren, im Wesentlichen parallel sind.

3. Karussell einer digitalen Objektträgerabtastvorrichtung nach Anspruch 2, wobei der erste Gestellschlitz (220) aus einer Draufsicht einen im Allgemeinen rechteckigen Bereich auf der oberen Oberfläche der Basis (100) definiert.

4. Karussell einer digitalen Objektträgerabtastvorrichtung nach Anspruch 3, wobei das erste Objektträgergestell (300) konfiguriert ist, um mehrere Glasobjektträger (310) zu tragen, die jeweils 2,54 cm mal 7,62 cm groß sind.

5. Karussell einer digitalen Objektträgerabtastvorrichtung nach Anspruch 2, wobei jeder von dem ersten Gestellabstandshalter (210) und dem zweiten Gestellabstandshalter (210) im Allgemeinen keilförmig ist.

6. Karussell einer digitalen Objektträgerabtastvorrichtung nach Anspruch 2, wobei der erste Gestellabstandshalter (210) und der zweite Gestellabstandshalter (210) mit der Basis verbunden sind und sich von der Basis (100) nach oben erstrecken.

7. Karussell einer digitalen Objektträgerabtastvorrichtung nach Anspruch 2, wobei der erste Gestellabstandshalter einen inneren Abschnitt proximal zu einem zentralen Abschnitt der Basis (100) umfasst und ferner einen ersten Gestellanschlag (240) umfasst, der sich von dem inneren Abschnitt des ersten Gestellabstandshalters (210) in Richtung des zweiten Gestellabstandshalters (210) und in den ersten Gestellschlitz (220) erstreckt.

8. Karussell einer digitalen Objektträgerabtastvorrichtung nach Anspruch 7, wobei der zweite Gestellabstandshalter (210) einen inneren Abschnitt proximal zu einem zentralen Abschnitt der Basis (100) umfasst und ferner einen zweiten Gestellanschlag (240) umfasst, der sich von dem inneren Abschnitt des zweiten Gestellabstandshalters in Richtung des ersten Gestellabstandshalters und in den ersten Gestellschlitz erstreckt.

9. Karussell einer digitalen Objektträgerabtastvorrichtung nach Anspruch 8, wobei der erste Gestellanschlag (240) und der zweite Gestellanschlag (240) konfiguriert sind, um in das erste Objektträgergestell (300) einzugreifen, das in dem ersten Gestellschlitz (220) positioniert ist.

10. Karussell einer digitalen Objektträgerabtastvorrichtung nach Anspruch 1, wobei die linke Seite des dritten Gestellabstandshalters und die rechte Seite des vierten Gestellabstandshalters, die den zweiten Gestellschlitz (230) definieren, im Wesentlichen parallel sind, wobei der zweite Gestellschlitz (230) aus einer Draufsicht einen im Allgemeinen rechteckigen Bereich auf der oberen Oberfläche der Basis (100) definiert und wobei jeder von dem dritten Gestellabstandshalter und dem vierten Gestellabstandshalter im Allgemeinen keilförmig ist.

11. Karussell einer digitalen Objektträgerabtastvorrichtung nach Anspruch 10, wobei das zweite Objektträgergestell (400) konfiguriert ist, um mehrere Glasobjektträger (410) zu tragen, die jeweils 5,06 cm mal 7,62 cm groß sind.

12. Karussell einer digitalen Objektträgerabtastvorrichtung nach Anspruch 10, wobei der dritte Gestellabstandshalter und der vierte Gestellabstandshalter mit der Basis (100) verbunden sind und sich von der Basis (100) nach oben erstrecken.

13. Karussell einer digitalen Objektträgerabtastvorrichtung nach Anspruch 10, wobei der dritte Gestellabstandshalter einen inneren Abschnitt proximal zu einem zentralen Abschnitt der Basis (100) umfasst und ferner einen dritten Gestellanschlag umfasst, der sich von dem inneren Abschnitt des dritten Gestellabstandshalters in Richtung des vierten Gestellabstandshalters und in den zweiten Gestellschlitz (230) erstreckt.

14. Karussell einer digitalen Objektträgerabtastvorrichtung nach Anspruch 13, wobei der vierte Gestellabstandshalter einen inneren Abschnitt proximal zu einem zentralen Abschnitt der Basis (100) umfasst und ferner einen vierten Gestellanschlag umfasst, der sich von dem inneren Abschnitt des vierten Gestellabstandshalters in Richtung des dritten Gestellabstandshalters und in den zweiten Gestellschlitz (230) erstreckt.

15. Karussell einer digitalen Objektträgerabtastvorrichtung nach Anspruch 14, wobei der dritte Gestellanschlag und der vierte Gestellanschlag konfiguriert sind, um in das zweite Objektträgergestell (400) einzugreifen, das konfiguriert ist, um mehrere Glasobjektträger (410) zu tragen, die jeweils 2 Zoll mal 3 Zoll groß sind, die in dem zweiten Gestellschlitz (400) positioniert sind.

## Revendications

1. Un carrousel pour appareil de scan numérique de lames, comprenant :
une base (100) avec une surface inférieure, une surface supérieure et un bord extérieur, le bord extérieur de la base étant globalement circulaire lorsqu'il est observé en vue de dessus ;
**caractérisé par** :
une pluralité de séparateurs de chargeurs amovibles (210) positionnés au-dessus de la base, chaque séparateur de chargeurs amovible (210) ayant un côté gauche, un côté droit, un côté extérieur, un côté intérieur, un dessus et un dessous, une pluralité de connecteurs de séparateur de chargeurs (110) étant formés sur la surface supérieure de la base (100), et les séparateurs de chargeurs amovibles (210) étant configurés pour être fixés à la base (100) par les connecteurs de séparateurs de chargeurs (110) ;
dans lequel une première paire de séparateurs de chargeurs adjacents, comprenant un premier séparateur de chargeurs et un second séparateur de chargeurs, définissent un premier compartiment de chargeur (220) bordé sur trois côtés par la base, par un côté gauche du premier séparateur de chargeurs et par un côté droit du second séparateur de chargeurs ; et
dans lequel une seconde paire de séparateurs de chargeurs adjacents, comprenant un troisième séparateur de chargeurs et un quatrième séparateur de chargeurs, définissent un second compartiment de chargeur (230) bordé sur trois côtés par la base (100), par un côté gauche du troisième séparateur de chargeurs et par un côté droit du quatrième séparateur de chargeurs ;
dans lequel les compartiments de chargeur sont configurés pour loger un chargeur de lames qui est configuré pour loger des lames.

2. Le carrousel pour appareil de scan numérique de lames de la revendication 1, dans lequel le côté gauche du premier séparateur de chargeurs (210) et le côté droit du second séparateur de chargeurs (210), qui définissent le premier compartiment de chargeur (220), sont sensiblement parallèles.

3. Le carrousel pour appareil de scan numérique de lames de la revendication 2, dans lequel le premier compartiment de chargeur (220) définit une zone globalement rectangulaire sur la surface supérieure de la base (100), en vue de dessus.

4. Le carrousel pour appareil de scan numérique de lames de la revendication 3, dans lequel le premier chargeur de lames (300) est configuré pour supporter une pluralité de lames en verre (310) qui ont chacune une dimension de 2,54 cm sur 7,62 cm.

5. Le carrousel pour appareil de scan numérique de lames de la revendication 2, dans lequel chacun du premier séparateur de chargeurs (210) et du second séparateur de chargeurs (210) est globalement cunéiforme.

6. Le carrousel pour appareil de scan numérique de lames de la revendication 2, dans lequel le premier séparateur de chargeurs (210) et le second séparateur de chargeurs (210) sont reliés à la base et s'étendent vers le haut à partir de la base.

7. Le carrousel pour appareil de scan numérique de lames de la revendication 2, dans lequel le premier séparateur de chargeurs comprend une partie intérieure proximale par rapport à une partie centrale de la base (100), et comprend en outre une première butée de chargeur (240) s'étendant de la partie intérieure du premier séparateur de chargeurs (210) vers le second séparateur de chargeurs (210) et jusque dans le premier compartiment de chargeur (220) .

8. Le carrousel pour appareil de scan numérique de lames de la revendication 7, dans lequel le second séparateur de chargeurs (210) comprend une partie intérieure proximale par rapport à une partie centrale de la base, et comprend en outre une seconde butée de chargeur (240) s'étendant de la partie intérieure du second séparateur de chargeurs vers le premier séparateur de chargeurs et jusque dans le premier compartiment de chargeur.

9. Le carrousel pour appareil de scan numérique de lames de la revendication 8, dans lequel la première butée de chargeur (240) et la seconde butée de chargeur (240) sont configurées pour s'engager avec le premier chargeur de lames (300) positionné dans le premier compartiment de chargeur (220).

10. Le carrousel pour appareil de scan numérique de lames de la revendication 1, dans lequel le côté gauche du troisième séparateur de chargeurs et le côté droit du quatrième séparateur de chargeurs, qui définissent le second compartiment de chargeur (230), sont sensiblement parallèles, dans lequel le second séparateur de chargeurs (230) définit une zone globalement rectangulaire sur la surface supérieure de la base (100) en vue de dessus, et dans lequel chacun du troisième séparateur de chargeurs et du quatrième séparateur de chargeurs est globalement cunéiforme.

11. Le carrousel pour appareil de scan numérique de lames de la revendication 10, dans lequel le second chargeur de lames (400) est configuré pour supporter une pluralité de lames en verre qui ont chacune une dimension de 5,06 cm sur 7,62 cm.

12. Le carrousel pour appareil de scan numérique de lames de la revendication 10, dans lequel le troisième séparateur de chargeurs et le quatrième séparateur de chargeurs sont reliés à la base (100) et s'étendent vers le haut à partir de la base (100).

13. Le carrousel pour appareil de scan numérique de lames de la revendication 10, dans lequel le troisième séparateur de chargeurs comprend une partie intérieure proximale par rapport à une partie centrale de la base (100), et comprend en outre une troisième butée de chargeur s'étendant de la partie intérieure du troisième séparateur de chargeurs vers le quatrième séparateur de chargeurs et jusque dans le second compartiment de chargeur (230).

14. Le carrousel pour appareil de scan numérique de lames de la revendication 13, dans lequel le quatrième séparateur de chargeurs comprend une partie intérieure proximale par rapport à une partie centrale de la base (100), et comprend en outre une quatrième butée de chargeur s'étendant de la partie intérieure du quatrième séparateur de chargeurs vers le troisième séparateur de chargeurs et jusque dans le second compartiment de chargeur (230).

15. Le carrousel pour appareil de scan numérique de lames de la revendication 14, dans lequel la troisième butée de chargeur et la quatrième butée de chargeur sont configurées pour s'engager avec le second chargeur de lames (400), configuré pour supporter une pluralité de lames en verre (410) qui ont chacune une dimension de 2 pouces sur 3 pouces, positionné dans le second compartiment de chargeur (400).
